# EUROPÄISCHE PATENTSCHRIFT

(11) **EP 3 256 264 B1**
(45) Veröffentlichungstag und Bekanntmachung des Hinweises auf die Patenterteilung: **29.09.2021**
(21) Anmeldenummer: 15816120.8
(22) Anmeldetag: 11.12.2015
(51) Int. Cl.: B06B 1/06, G10K 11/00, H01L 41/047

(54) **SCHALLWANDLER UMFASSEND EINE VIELZAHL VON EINZELWANDLERN UND VERFAHREN ZU DESSEN HERSTELLUNG**
SOUND TRANSDUCER COMPRISING A PLURALITY OF SINGLE TRANSDUCERS AND METHOD FOR THE PRODUCTION THEREOF
TRANSDUCTEUR ACOUSTIQUE COMPRENANT UNE PLURALITÉ DE TRANSDUCTEURS INDIVIDUELS ET SON PROCÉDÉ DE FABRICATION

(30) Priorität: 11.02.2015 DE 102015202393
(43) Veröffentlichungstag der Anmeldung: 20.12.2017
(73) Patentinhaber: Robert Bosch GmbH, 70442 Stuttgart (DE)
(72) Erfinder: GERLACH, Andre, 71229 Leonberg-Hoefingen (DE); SCHEUFELE, Bernd, 73257 Koengen (DE)
(86) Internationale Anmeldenummer: PCT/EP2015/079379
(87) Internationale Veröffentlichungsnummer: WO 2016/128093

(56) Entgegenhaltungen:
- WO-A2-2011/073414
- DE-A1-102004 057 795
- DE-A1-102008 055 126
- DE-A1-102013 213 493
- US-A- 3 950 660

## Beschreibung

Die Erfindung betrifft einen Schallwandler umfassend eine Vielzahl von Einzelwandlern, wobei die Einzelwandler einen Träger und ein piezoelektrisches Element mit einer ersten Elektrode und einer zweiten Elektrode umfassen. Des Weiteren betrifft die Erfindung ein Verfahren zur Herstellung eines solchen Schallwandlers.

### Stand der Technik

Schallwandler kommen beispielsweise in ultraschallbasierenden Sensoren zum Einsatz, mit denen sich der Abstand zwischen dem Ultraschallsensor und einem reflektierenden Objekt messen lässt. Der Schallwandler dient darin als Sender und/oder Empfänger, wobei in einem ersten Schritt durch den Schallwandler ein Ultraschallsignal abgestrahlt wird. Trifft das Ultraschallsignal auf ein reflektierendes Objekt, dann wird ein Ultraschallecho erzeugt, welches über den Schallwandler wieder detektiert werden kann. Aus der Zeit, die zwischen Aussenden des Ultraschallsignals und dem Detektieren des Ultraschallechos vergangen ist, sowie der bekannten Schallgeschwindigkeit, kann die Entfernung zum reflektierenden Objekt berechnet werden. Da die Schallausbreitung im Allgemeinen nicht stark gerichtet erfolgt, lässt sich die Richtung, aus der ein Echo einfällt, nicht mit einem einzelnen Schallwandler bestimmen.

Werden mehrere einzelne Schallwandler zu einem Array von Einzelwandlern zusammengefasst, deren Abstand typischerweise untereinander weniger als die halbe Schallwellenlänge beträgt, dann kann durch Ausnutzung von Interferenz zum einen eine gerichtete Schallabstrahlung erreicht werden und zum anderen auch eine detaillierte Analyse der empfangenen Signale durchgeführt werden. Dies wird auch als "Beamforming" bezeichnet. Wird bei einer solchen Analyse das gesamte von den Einzelwandlern des Arrays ermittelte Schallfeld ausgewertet, dann lässt sich beispielsweise auch die Richtung bestimmen, aus der ein Signal empfangen wurde.

Die Fertigung eines Schallwandlers, der ein Array mit einer Vielzahl von Einzelwandlern umfasst, ist jedoch sehr komplex, da jeder Einzelwandler getrennt ansteuerbar sein muss und eine schwingungsmechanische Entkopplung der Einzelwandler untereinander erforderlich ist.

Aus DE 10 2012 201 715 A1 ist ein Prüfkopf zur Prüfung eines Werkstücks bekannt, der mit einer Vielzahl von Ultraschallwandlern bestückt ist. Die Ultraschallwandler sind auf einer flexiblen Leiterfolienanordnung über einen elektrisch leitfähigen Klebstoff befestigt. Die Ultraschallwandler umfassen einen Piezostapel und werden an zwei Seiten elektrisch kontaktiert, wobei eine Seite mit der flexiblen Leiterfolienanordnung in Verbindung steht und die andere Seite mit einer Erdungsfolie verbunden ist. Zwischen den einzelnen

Ultraschallwandlern kann zur Dämpfung ein dauerelastisches Material eingebracht werden. DE 10 2013 213 493 A1 beschreibt eine Schallwandleranordnung mit einem Gehäuse, in dem ein oder mehrere Wandlerelemente angeordnet sind. Der Zwischenraum zwischen dem Gehäuse um den Wandlerelementen ist mit einem Kunststoff abgedichtet.

Nachteilig am Stand der Technik ist, dass große Teile der einzelnen Schallwandler nicht vom Dämpfungsmaterial überdeckt sind.

### Offenbarung der Erfindung

Es wird ein Schallwandler umfassend eine Vielzahl von Einzelwandlern vorgeschlagen, wobei die Einzelwandler einen Träger und ein piezoelektrisches Element mit einer ersten Elektrode und einer zweiten Elektrode umfassen. Dabei ist vorgesehen, dass die Einzelwandler in Form eines Arrays auf einer flexiblen Folie aufgeklebt sind und dass alle nicht mit der flexiblen Folien verbundenen

Oberflächen der Einzelwandler von einem Vergussmaterial mit schwingungsdämpfenden Eigenschaften umgeben sind.

Die flexible Folie stellt dabei für alle Einzelwandler eine gemeinsame Halterung dar, an der alle Einzelwandler aufgenommen sind. Dabei sind die Einzelwandler so mit der flexiblen Folie verklebt, dass von den Einzelwandlern erzeugter Schall über die flexible Folie an die Umgebung abgegeben wird und umgekehrt Schall aus der Umgebung sich über die flexible Folie auf die Einzelwandler überträgt. Zusätzlich stellt die flexible Folie eine Abdichtung der an dieser aufgeklebten Einzelwandler gegenüber der Umgebung dar, so dass Feuchtigkeit und andere Umwelteinflüsse nicht zu den Einzelwandlern gelangen können.

Bei der flexiblen Folie handelt es sich bevorzugt um eine Kunststofffolie, beispielsweise eine Folie aus Polyimid (PI), Polyethylenterephthalat (PET) oder Polyethylennaphthalat (PEN). Alternativ handelt es sich bei der Folie um einen Verbundwerkstoff, beispielsweise umfassend Kohlefaser- oder Glasfasergewebe und Harz.

Bevorzugt weist die flexible Folie eine Dicke im Bereich von 30 bis 750 µm auf. Die Wahl dieser Foliendicke stellt einen guten Kompromiss zwischen der Schutzwirkung gegen äußere Einwirkungen und einer ausreichenden Beweglichkeit bzw. Nachgiebigkeit der Folie für eine gute Schallabstrahlung und einen guten Schallempfang dar.

Die den Einzelwandlern abgewandte Seite der flexiblen Folie kann des Weiteren beschichtet werden oder mit einer Lackierung versehen werden. Dadurch kann eine Messeinrichtung, die den erfindungsgemäßen Schallwandler einsetzt, beispielsweise gut in das Design von Fahrzeugen integriert werden.

An der den Einzelwandlern zugewandten Seite der flexiblen Folie ist ein Vergussmaterial angeordnet, welches die Zwischenräume zwischen den Einzelwandlern ausfüllt und sämtliche nicht bereits mit der flexiblen Folie verbundenen Oberflächen der Einzelwandler überdeckt. Somit sind die Einzelwandler vollständig von dem Vergussmaterial und der flexiblen Folie umschlossen.

Das verwendete Vergussmaterial weist schwingungsdämpfende Eigenschaften auf. Dazu ist das Vergussmaterial bevorzugt dauerelastisch ausgeführt und weist bevorzugt eine schaumartige Struktur auf. Als Vergussmaterial ist beispielsweise ein unter der Bezeichnung Fermasil von der Firma Sonderhoff vertriebener zweikomponentiger Silikonschaum geeignet. Möglich sind auch Silikonbasierende Polymere mit enthaltenen Glas- oder Kunststoff-Hohlkugeln. Alternativ sind als Vergussmaterial auch nicht Silikon-basierte Polymere mit oder ohne Gaseinschlüsse geeignet.

Die Einzelwandler werden in Form eines Arrays auf der flexiblen Folie angeordnet, insbesondere aufgeklebt. Das Array umfasst dabei typischerweise eine Anzahl im Bereich von 2 bis 250 Einzelwandler, wobei eine Anzahl im Bereich von 5 bis 50 bevorzugt wird.

In dem Array können die Einzelwandler symmetrisch oder unsymmetrisch angeordnet sein, beispielsweise in Form eines Rasters oder eines Ringes, wobei auch jede andere dem Fachmann bekannte geometrische Anordnung möglich ist. Der Abstand benachbart angeordneter Einzelwandler beträgt typischerweise weniger als die halbe Schallwellenlänge und die einzelnen Abstände können gleich oder unterschiedlich groß gewählt werden.

Jeder Einzelwandler umfasst ein piezoelektrisches Element, welches bei Anregung mit einem elektrischen Signal in Schwingung versetzt werden kann bzw. wenn es von außen, beispielsweise durch eine empfangene Schallwelle, zur Schwingung angeregt wird, diese in ein elektrisches Signal umwandeln kann. Die piezoelektrischen Elemente sind jeweils mit einer ersten Elektrode und einer zweiten Elektrode elektrisch kontaktiert und es ist vorgesehen, dass jeder Einzelwandler des Arrays bzw. des Schallwandlers getrennt elektrisch angeregt werden kann bzw. deren empfangenen Signale getrennt ausgewertet werden können. Dazu muss jeder Einzelwandler unabhängig von den anderen elektrisch ansteuerbar sein.

Bei dem piezoelektrischen Element kann es sich beispielsweise um ein Element aus einer piezoelektrischen Keramik handeln, beispielsweise um einen piezokeramischen Werkstoff, der unter der Bezeichnung Sonox P5 von der Firma CeramTec erhältlich ist. Der Träger der Einzelwandler besteht je nach Ausführungsvariante bevorzugt aus einem Metall, beispielsweise Aluminium, eine Aluminiumlegierung oder Stahl, aus einer Keramik, beispielsweise Aluminiumoxid, Siliziumkarbid oder Siliziumnitrid oder einem Kunststoff, beispielsweise einem Glasfaser-Verbundwerkstoff oder einem Kohlefaser-Verbundwerkstoff. Der Träger weist bevorzugt eine U-Form auf, wobei das piezoelektrische Element an den Schenkeln des U's mit dem Träger verbunden ist, beispielsweise durch Kleben. In einer anderen Ausführungsvariante besteht der Träger aus einem piezokeramischen Material, welches in einem Bereich polarisiert wurde, so dass der polarisierte Bereich piezoelektrische Eigenschaften aufweist und das piezoelektrische Element bildet.

In einer Ausführungsform des Schallwandlers weist die flexible Folie auf der den Einzelwandlern zugewandten Seite eine erste Metallisierung beispielsweise aus Kupfer, Aluminium oder Nickel mit einer Dicke von 1 µm bis 125 µm auf und die erste Elektrode eines jeden Einzelwandlers ist über die erste Metallisierung der flexiblen Folie elektrisch kontaktiert. Dabei ist vorgesehen, dass zum Aufkleben der Einzelwandler auf die flexible Folie ein leitfähiger Klebstoff verwendet wird. Als leitfähiger Klebstoff ist beispielsweise der isotrop leitfähige Klebstoff PC 3000 der Firma Heraeus oder der anisotrop leitfähige Klebstoff Delomonopox AC 265 der Firma DELO geeignet. Je nach Ausführungsvariante kann der leitfähige Klebstoff nur an den Punkten aufgetragen werden, an denen tatsächlich ein elektrischer Kontakt zwischen der ersten Elektrode eines Einzelwandlers und der ersten Metallisierung hergestellt werden soll. Alternativ kann der leitfähige Klebstoff auch vollflächig aufgetragen werden.

Die zweite Elektrode eines jeden Einzelwandlers wird in dieser Ausführungsform mithilfe eines Drahtes elektrisch kontaktiert, der durch das Vergussmaterial hindurchgeführt und am Träger des Einzelwandlers vorbeigeführt ist und bevorzugt durch Bonden, Thermokompressionsschweißen, Löten oder Leitkleben an der zweiten Elektrode angeschlossen wird.

In einer weiteren Variante ist der Träger jedes Einzelwandlers elektrisch leitfähig ausgeführt, wobei der Träger die zweite Elektrode des piezoelektrischen Elements elektrisch kontaktiert. Dabei ist vorgesehen, dass die flexible Folie auf der den Einzelwandlern zugewandten Seite eine erste Metallisierung aufweist und die erste Elektrode eines jeden Einzelwandlers über die erste Metallisierung der flexiblen Folie elektrisch kontaktiert ist. Eine elektrische Verbindung zur zweiten Elektrode wird über einen durch das Vergussmaterial hindurchführenden Draht hergestellt, wobei der bevorzugt durch Boden, Thermokompressionsschweißen, Löten oder Leitkleben angeschlossene Draht den Träger des Einzelwandlers kontaktiert, der wiederum elektrisch leitend mit der zweiten Elektrode verbunden ist. In dieser Ausführungsform kann die Verbindung zwischen dem Träger und dem Piezoelement bzw. der zweiten Elektrode des Piezoelements durch Verkleben hergestellt werden, wobei ein leitfähiger Klebstoff verwendet wird.

In einer weiteren Ausführungsform des Schallwandlers weist die flexible Folie ebenfalls auf der dem Einzelwandler zugewandten Seite eine erste Metallisierung auf. Der Träger jedes Einzelwandlers ist elektrisch leitfähig ausgeführt und weist an seiner der flexiblen Folie zugewandten Seite eine Membran auf, wobei das piezoelektrische Element auf der der flexiblen Folie abgewandten Seite der Membran angeordnet ist. Die Membran ist bevorzugt aus dem gleichen Material wie der Träger gefertigt und ist ebenfalls elektrisch leitfähig, so dass die erste Elektrode des piezoelektrischen Elements zunächst die Membran des Trägers kontaktiert und über die Membran mit der ersten Metallisierung der flexiblen Folie in elektrischer Verbindung steht. Für das Herstellen einer elektrischen Verbindung zur zweiten Elektrode des piezoelektrischen Elements wird bevorzugt ein Draht verwendet, der durch das Vergussmaterial hindurchführt und die zweite Elektrode kontaktiert.

In einer weiteren Ausführungsform des Schallwandlers weist die flexible Folie eine erste Metallisierung auf, die in Form von Leiterbahnen strukturiert ist. Die erste Metallisierung weist erste und zweite Leiterbahnen auf, wobei mit den ersten Leiterbahnen jeweils die erste Elektrode eines jeden Einzelwandlers elektrisch kontaktiert ist und die zweite Elektrode eines jeden Einzelwandlers mit den zweiten Leiterbahnen elektrisch kontaktiert ist. Drähte sind in dieser Ausführungsform vorteilhaft nicht erforderlich. Die ersten und/oder zweiten Leiterbahnen können Kontaktflächen umfassen, die an der elektrischen Kontaktierung der Elektroden des piezoelektrischen Elements eingerichtet sind.

Zum Herstellen der elektrischen Verbindungen zwischen den ersten und zweiten Leiterbahnen und den ersten und zweiten Elektroden der Einzelwandler wird ein leitfähiger Klebstoff verwendet. Dabei wird in einer Variante der Erfindung der leitfähige Klebstoff nur an solchen Stellen auf die flexible Folie aufgetragen, an denen auch eine elektrische Verbindung zwischen der ersten Metallisierung der flexiblen Folie und einer der Elektroden des piezoelektrischen Elements hergestellt werden soll.

In einer weiteren Variante der Erfindung wird ein leitfähiger Klebstoff mit anisotroper Leitfähigkeit eingesetzt. Der leitfähige Klebstoff kann in diesem Fall vollflächig auf der ersten Metallisierung der flexiblen Folie aufgetragen werden, ohne dass es zu Kurzschlüssen zwischen den ersten und den zweiten Leiterbahnen bzw. den ersten und zweiten Elektroden der Einzelwandler kommt. Dies wird dadurch erreicht, dass aufgrund der Anisotropie in der Leitfähigkeit der verwendete Klebstoff lediglich in einer Richtung senkrecht zur Schichtebene eine wesentlich elektrische Leitfähigkeit aufweist. In Richtungen, die innerhalb der Schichtebene liegen, verschwindet die Leitfähigkeit oder ist vernachlässigbar.

In einer weiteren Ausführungsform des Schallwandlers sind am Träger eines jeden Einzelwandlers sowohl für die erste Elektrode als auch für die zweite Elektrode seitlich Kontakte herausgeführt, die jeweils mit einem Draht durch das Vergussmaterial hindurch elektrisch kontaktiert sind. Hierbei ist mit seitlich gemeint, dass die seitlichen Kontakte an einer Fläche des Trägers angeordnet sind, die im Wesentlichen senkrecht zur flexiblen Folie orientiert ist. In dieser Ausführungsform weist die flexible Folie bevorzugt keine erste Metallisierung auf und zur Verbindung der Einzelwandler mit der flexiblen Folie ist kein Klebstoff mit elektrischer Leitfähigkeit erforderlich.

Der bei den verschiedenen Ausführungsvarianten eingesetzte Einzelwandler umfasst einen Träger und ein piezoelektrisches Element. Diese können in einer Variante als zwei Bauteile ausgeführt sein, die miteinander verbunden werden, beispielsweise durch Kleben. Ist der Träger aus einem elektrisch leitfähigen Material ausgeführt, kann durch den Einsatz eines Klebstoffs mit elektrischer Leitfähigkeit dabei eine elektrisch leitende Verbindung zwischen dem Träger und einer der Elektroden des piezoelektrischen Elements erfolgen.

Alternativ dazu kann der Träger aus einem piezokeramischen Material gefertigt sein und das piezoelektrische Element kann als polarisierter Bereich des Trägers ausgebildet sein. Dabei weist der Träger nur in dem polarisierten Bereich piezoelektrische Eigenschaften auf. Die erste und die zweite Elektrode des piezoelektrischen Elements werden in dieser Ausführungsform entsprechend an den Grenzen des polarisierten Bereichs des Trägers angeordnet.

Bevorzugt ist vorgesehen, dass die flexible Folie auf der den Einzelwandlern abgewandten Seite eine zweite Metallisierung aufweist. Diese zweite Metallisierung kann geerdet werden, so dass eine Abschirmung zur Verbesserung der elektromagnetischen Verträglichkeit (EMV) erzielt wird. Für die zweite Metallisierung ist beispielsweise eine Metallschicht aus Kupfer, Aluminium oder Nickel in einer Dicke von 1 µm bis 125 µm geeignet. Gegebenenfalls kann die Metallschicht zum Schutz vor Oxidation vergoldet werden.

Ein weiterer Aspekt der Erfindung ist es, ein Verfahren zur Herstellung eines solchen Schallwandlers bereitzustellen. Das vorgeschlagene Verfahren umfasst die Schritte:
a) Breitstellen der flexiblen Folie und der Einzelschallwandler,
b) Verkleben der Einzelschallwandler mit der flexiblen Folie, wobei die Einzelschallwandler in Form eines Arrays auf der flexiblen Folie angeordnet werden, und
c) Umschließen der Einzelschallwandler mit einem Vergussmaterial mit schwingungsdämpfenden Eigenschaften, so dass alle nicht mit der flexiblen

Folie verbundenen Oberflächen der Einzelwandler von dem Vergussmaterial umgeben sind.

Im ersten Schritt a) des Verfahrens werden die flexible Folie und die Einzelschallwandler bereitgestellt. Bei der flexiblen Folie handelt es sich um eine Kunststofffolie, mit einer Dicke im Bereich von 30 µm bis 750 µm. Das Material der Kunststofffolie ist beispielsweise ausgewählt aus Polyimid (PI), Polyethylenterephthalat (PET) oder Polyethylennaphthalat (PEN)..

Die Einzelwandler umfassen jeweils ein piezoelektrisches Element und einen Träger, wobei das piezoelektrische Element eine erste Elektrode und eine zweite Elektrode aufweist. In einer Ausführungsvariante sind der Träger und das piezoelektrische Element aus zwei Bauteilen zusammengesetzt, die miteinander verklebt werden. Dabei kann, wenn der Träger elektrisch leitfähig ausgestaltet ist, ein elektrisch leitfähiger Klebstoff verwendet werden.

In einer weiteren Variante sind der Träger und das piezoelektrische Element aus einem Bauteil gefertigt, wobei der Träger aus einem piezokeramischen Material besteht, welches in einem Bereich polarisiert worden ist. Dieser polarisierte Bereich bildet dann das piezoelektrische Element aus.

Im letzten Schritt c) des Verfahrens werden die Einzelwandler mit dem Vergussmaterial mit schwingungsdämpfenden Eigenschaften umschlossen.

Dabei füllt das Vergussmaterial die Zwischenräume zwischen den Einzelwandlern aus und umschließt alle Oberflächen der Einzelwandler, die nicht mit der flexiblen Folie verklebt sind.

In einer Ausführungsform des Verfahrens wird beim Verkleben gemäß Schritt b) ein leitfähiger Klebstoff verwendet. Der leitfähige Klebstoff wird dabei flächig auf die flexible Folie aufgetragen und anschließend werden die Einzelwandler angeordnet. Dabei ist ferner vorgesehen, dass in Ausführungsvarianten, bei denen die flexible Folie eine erste Metallisierung aufweist und so strukturiert ist, dass erste und zweite Leiterbahnen ausgebildet sind, ein anisotroper Leitkleber als leitfähiger Klebstoff verwendet wird. Der anisotrope Leitkleber weist nur in einer Richtung senkrecht zur Schicht bzw. senkrecht zur flexiblen Folie eine elektrische Leitfähigkeit auf. In Raumrichtungen, die in der Ebene der flexiblen Folie liegen, verschwindet die elektrische Leitfähigkeit oder ist sehr klein. Auf diese Weise kann auch bei Ausführungsformen, bei denen sowohl die erste als auch die zweite Elektrode über die erste Metallisierung der flexiblen Folie kontaktiert werden, ein elektrischer Kurzschluss zwischen den ersten und zweiten Elektroden vermieden werden. Gleichzeitig ist es nicht erforderlich, den leitfähigen Klebstoff nur auf den Punkten aufzutragen, an denen tatsächlich eine elektrische Verbindung zwischen der ersten Metallisierung und einer der Elektroden des piezoelektrischen Elements hergestellt werden muss.

In Ausführungsformen des Schallwandlers, bei denen keine der Elektroden des piezoelektrischen Elements oder lediglich eine der beiden Elektroden des piezoelektrischen Elements über die erste Metallisierung der flexiblen Folie elektrisch kontaktiert werden ist vorgesehen, dass nach dem Verkleben gemäß Schritt b) und vor dem Umschließen gemäß Schritt c) die erste Elektrode und/oder die zweite Elektrode eines jeden Einzelwandlers durch Anschließen eines Drahtes elektrisch kontaktiert wird.

Beim Anschließen wird ein elektrisch leitfähiger Draht mit der jeweiligen Elektrode durch Bonden, Thermokompressionsschweißen, Löten oder Leitkleben verbunden, so dass eine elektrische Verbindung entsteht. Nach dem Umschließen der Einzelwandler gemäß Schritt c) sind die Drähte in dem Vergussmaterial eingebettet, wobei diese durch das Vergussmaterial hindurchführen zu der jeweiligen Elektrode.

### Vorteile der Erfindung

Bei dem vorgeschlagenen Schallwandler sind die Einzelwandler praktisch vollständig voneinander schwingungsentkoppelt. Die Einzelwandler sind lediglich durch eine Verklebung an einer flexiblen Folie gehalten, über die Schwingungen zwischen zwei Einzelwandlern nur schlecht übertragen werden. Alle weiteren Oberflächen der Einzelwandler, die nicht mit der flexiblen Folie verbunden sind, werden durch ein Vergussmaterial mit schwingungsdämpfenden Eigenschaften umschlossen. Die verwendete flexible Folie kann zwar Schwingungen von den Einzelwandlern an die Umgebung, beispielsweise an Luft, übertragen und ebenso Schwingungen aus der Umgebung an die Einzelwandler übertragen, eine Ausbreitung der Schwingungen in der Ebene der Folie, beispielsweise auf benachbarte Einzelwandler, findet jedoch kaum statt.

Die flexible Folie stellt zudem eine gemeinsame Halterung für die Einzelwandler in dem Schallwandler bereit, die vorteilhafterweise kaum Schallwellen bzw. Schwingungen zwischen den Einzelwandlern überträgt.

Die vorgeschlagene flexible Folie ist zudem geeignet, die an der Rückseite der Folie angeordneten Schallwandler vor rauen Umgebungsbedingungen wie hoher Luftfeuchtigkeit, Wasser oder UV-Strahlung oder mechanischen Einflüssen wie Steinschlag zu schützen. Zusätzliche Gehäuseteile werden im Bereich der flexiblen Folie nicht mehr benötigt, wenn der Schallwandler in einem Sensor integriert wird.

Wird der Schallwandler beispielsweise in einem Sensor eingesetzt, kann die flexible Folie leicht lackiert werden, so dass sich ein Sensor, der mit dem erfindungsgemäßen Schallwandler ausgerüstet ist, beispielsweise in Automobilanwendungen leicht in das Design des Fahrzeugs integrieren lässt.

Zudem lässt sich der erfindungsgemäße Schallwandler einfach fertigen, da er nur aus wenigen Komponenten besteht und sich die elektrische Kontaktierung der Einzelwandler leicht bewerkstelligen lässt. Der vorgeschlagene Aufbau ist für eine sequentielle und einfache Realisierung der Aufbauschritte besonders geeignet.

### Kurze Beschreibung der Figuren

Ausführungsbeispiele der Erfindung sind in den Zeichnungen dargestellt und der nachfolgenden Beschreibung näher erläutert.

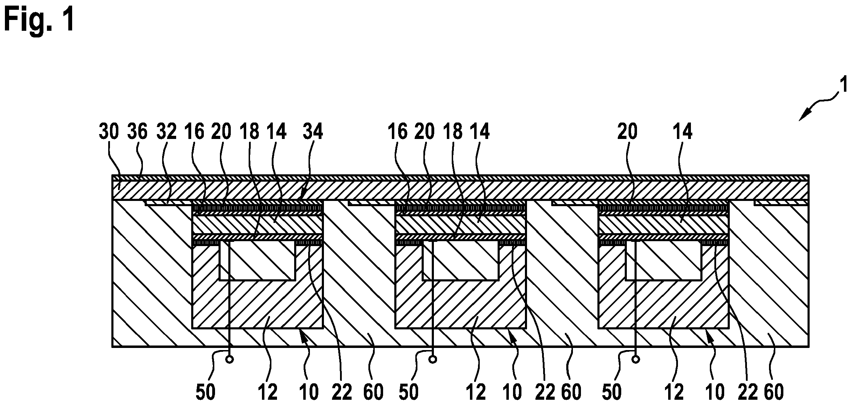

Die Figuren 1 bis 6 zeigen sechs verschiedene Ausführungsformen eines Schallwandlers.

In der nachfolgenden Beschreibung der Ausführungsbeispiele der Erfindung werden gleiche oder ähnliche Komponenten der Elemente mit gleichen Bezugszeichen bezeichnet, wobei auf eine wiederholte Beschreibung dieser Komponenten oder Elemente in Einzelfällen verzichtet wird. Die Figuren stellen den Gegenstand der Erfindung nur schematisch dar.

Figur 1 zeigt eine erste Ausführungsform eines Schallwandlers.

In Figur 1 ist ein Schallwandler 1 dargestellt, der beispielhaft drei Einzelwandler 10 umfasst. In weiteren Ausführungsvarianten kann der Schallwandler von zwei bis zweihundertfünfzig Einzelwandler 10 umfassen.

Jeder Einzelwandler 10 umfasst einen Träger 12 sowie ein piezoelektrisches Element 14. In der Ausführungsform der Figur 1 sind das piezoelektrische Element 14 und der Träger 12 als separate Bauteile ausgeführt und sind über eine Verklebung 22 miteinander verbunden. Das piezoelektrische Element 14 umfasst eine erste Elektrode 16, die dem Träger 12 abgewandt ist, sowie eine zweite Elektrode 18, die dem Träger 12 zugewandt ist. Die Einzelwandler 10 sind als Biegeschwinger ausgeführt, das heißt bei Anlegung eines elektrischen Signals an die Elektroden 16 und 18 führt das piezoelektrische Element 14 eine Schwingung mit in Richtung der Elektroden 16, 18 ausgedehnten Schwingungsbäuchen aus. Die Träger 12 sind bevorzugt U-förmig ausgestaltet, wobei das piezoelektrische Element 14 über die Verklebung 22 mit den Schenkeln des U-förmigen Trägers 12 verbunden ist.

Der Schallwandler 1 umfasst ferner eine flexible Folie 30, die beispielsweise als Kunststofffolie mit einer Dicke von 30 µm bis 750 µm aus Polyimid, Polyethylenterephthalat (PET) oder Polyethylennaphthalat (PEN) ausgeführt ist. Dabei zeigt eine Seite der flexiblen Folie 30 in Richtung der Einzelwandler 10. Auf dieser den Einzelwandlern 10 zugewandten Seite, umfasst die flexible Folie 30 eine erste Metallisierung 32. Über eine leitfähige Verklebung 20 sind die Einzelwandler 10 mit der flexiblen Folie 30 verklebt, wobei die Einzelwandler 10 in Form eines Arrays auf der flexiblen Folie 30 angeordnet sind. Dabei zeigen die Einzelwandler 10 mit ihrem piezoelektrischen Element 14 in Richtung der flexiblen Folie 30, wobei mithilfe der leitfähigen Verklebung 20 eine elektrisch leitende Verbindung zwischen der ersten Metallisierung 32 und der ersten Elektrode 16 der piezoelektrischen Elemente 14 hergestellt wird.

Zur Kontaktierung der zweiten Elektrode 18 eines jeden Einzelwandlers 10 wird jeweils ein Draht 50 verwendet.

Der Schallwandler 1 umfasst zudem ein Vergussmaterial 60, welches schwingungsdämpfende Eigenschaften aufweist. Das Vergussmaterial 60 wird auf der den Einzelwandlern 10 zugewandten Seite der flexiblen Folie 30 angeordnet und füllt die Zwischenräume zwischen den Einzelwandlern 10 auf. Des Weiteren ist das Vergussmaterial 60 so angeordnet, dass es alle Oberflächen der Einzelwandler 10 überdeckt, die nicht über die leitfähige Verklebung 20 mit der flexiblen Folie in Verbindung stehen.

Die Einzelwandler 10 können jeweils über den Ihnen zugeordneten Draht 50 und die erste Metallisierung 32 individuell mit einem elektrischen Signal angeregt werden. Dadurch kann der Schallwandler 1 Interferenzeffekte zwischen den Einzelwandlern 10 ausnutzen, um beispielsweise ein gerichtetes Ultraschallsignal zu erzeugen. Dabei werden die Einzelwandler 10 jeweils mit einem elektrischen Signal angesteuert, woraufhin die als Biegeschwinger wirkenden piezoelektrischen Elemente 14 zu schwingen beginnen. Die Schwingung überträgt sich auf die flexible Folie 30, die die Schwingung wiederum auf das umgebende Medium Luft überträgt, so dass Schall, insbesondere Ultraschall, entsteht.

Umgekehrt führen Schallwellen zu einer Schwingung der flexiblen Folie 30, die sich auf die mit der flexiblen Folie 30 verklebten piezoelektrischen Elemente 14 überträgt. Die piezoelektrischen Elemente 14 setzen die Schwingungen in elektrische Signale um, die für jeden Einzelwandler 10 getrennt mithilfe des jeweiligen Drahtes 50 der Kontaktierung über die erste Metallisierung 32 ausgelesen werden können.

Zudem ist es möglich, wie in Figur 1 dargestellt, die erste Metallisierung 32 zu strukturieren, so dass Kontaktflächen 34 ausgebildet werden. Dabei ist es möglich, dass die leitfähige Verklebung 20 nur im Bereich der Kontaktflächen 34 ausgeführt wird, so dass eine direkte elektrische Verbindung zwischen zwei ersten Elektroden 16 von zwei verschiedenen piezoelektrischen Elementen 14 nicht stattfindet.

Zur Herstellung einer Abschirmung zur Verbesserung der elektromagnetischen Verträglichkeit (EMV) weist die flexible Folie 30 auf der den Einzelwandlern 10 abgewandten Seite eine zweite Metallisierung 36 auf. Diese zweite Metallisierung 36 wird zum Herstellen der Abschirmung geerdet.

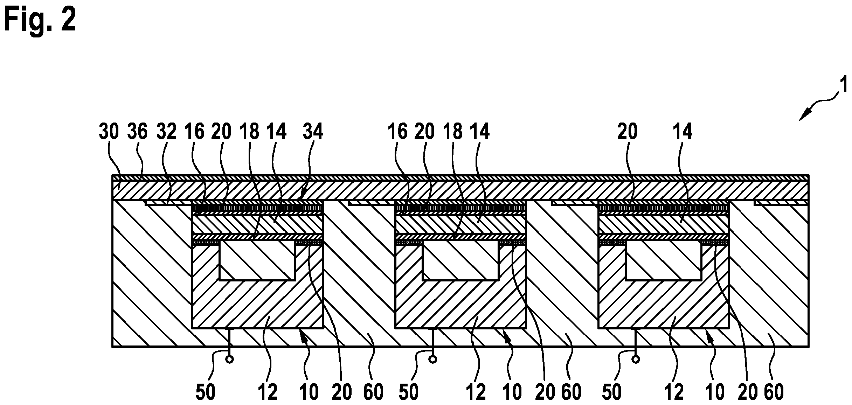

Figur 2 zeigt eine zweite Ausführungsform des Schallwandlers.

Der in Figur 2 dargestellte Schallwandler 1 umfasst wieder ein Array von Einzelwandlern 10, die mit der flexiblen Folie 30 verbunden sind. Wiederum sind in der Figur 2 beispielhaft drei Einzelwandler 10 dargestellt.

Die Einzelwandler 10 der in Figur 2 dargestellten Ausführungsform umfassen den U-förmigen Träger 12, der hier allerdings aus einem elektrisch leitfähigen Material, vorzugsweise aus einer Aluminiumlegierung oder einem anderen Metall, gefertigt ist. Der Träger 12 und das piezoelektrische Element 14 sind als zwei getrennte Bauteile ausgestaltet, wobei das piezoelektrische Element 14 die erste Elektrode 16 und die zweite Elektrode 18 aufweist. Über die leitfähige Verklebung 20 ist die zweite Elektrode 18 mit den Schenkeln des U-förmigen Trägers 12 verklebt, wobei zwischen dem Träger 12 und der zweiten Elektrode 18 eine elektrisch leitfähige Verbindung hergestellt wird.

Zur elektrischen Kontaktierung der zweiten Elektrode 18 des Einzelwandlers 10 ist ferner der Träger 12 über den oder die Drähte 50 kontaktiert.

Die ersten Elektroden 16 der Einzelwandler 10 werden genau wie bei der ersten Ausführungsform kontaktiert, das heißt die flexible Folie 30 weist die erste Metallisierung 32 auf, die über die leitfähige Verklebung 20 mit der ersten Elektrode 16 eines jeden Einzelwandlers 10 in Verbindung steht.

Ebenfalls wie zu Figur 1 beschrieben sind die nicht mit der flexiblen Folie 30 verklebten Oberflächen der Einzelwandler 10 vollständig von dem Vergussmaterial 60 eingeschlossen.

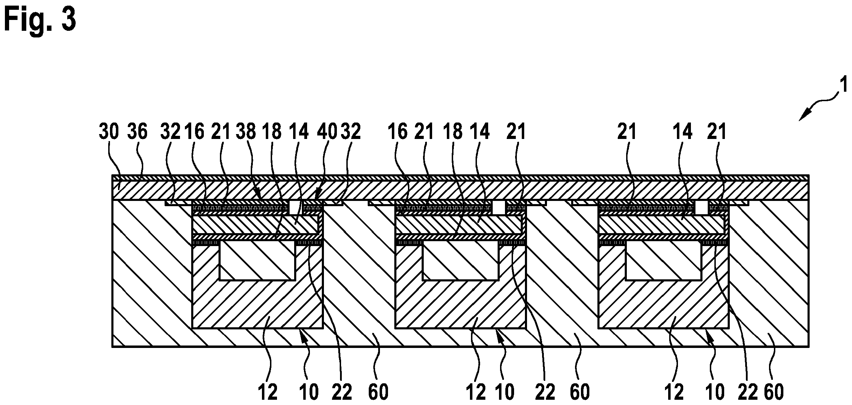

Figur 3 zeigt eine dritte Ausführungsform des Schallwandlers.

Der in Figur 3 dargestellte Schallwandler 1 umfasst wie bei den zuvor beschriebenen Ausführungsformen drei Einzelwandler 10, die durch Verkleben mit der flexiblen Folie 30 verbunden sind. Die Einzelwandler 10 der dritten Ausführungsform umfassen einen U-förmigen Träger 12 und das piezoelektrische Element 14, welches über eine Verklebung 22 an den Schenkeln des U-förmigen Trägers 12 befestigt ist. Dabei zeigt die zweite Elektrode 18 des piezoelektrischen Elements 14 in Richtung des Trägers 12 und die erste Elektrode 16 des piezoelektrischen Elements 14 in Richtung der flexiblen Folie 30. Dabei überdeckt die erste Elektrode 16 die der flexiblen Folie 30 zugewandte Seite des piezoelektrischen Elements 14 nicht vollständig, sondern lässt im Bereich eines der Schenkel des U-förmigen Trägers 12 einen Bereich frei.

Die zweite Elektrode 18 wird in dieser Ausführungsform um den Rand des piezoelektrischen Elements herumgeführt, so dass diese bis zu dem freien Bereich auf der der flexiblen Folie 30 zugewandten Seite des piezoelektrischen Elements 14 reicht. Die zweite Elektrode 18 überdeckt somit die dem Träger 12 zugewandte Seite des piezoelektrischen Elements 14 vollständig sowie einen kleinen Teil der der flexiblen Folie 30 zugewandten Seite.

Die flexible Folie 30 weist wie bei den beiden vorangehend beschriebenen Ausführungsformen die erste Metallisierung 32 auf, wobei diese in der dritten Ausführungsform in Form von Leiterbahnen 38, 40 strukturiert ist. Dabei weist die erste Metallisierung 32 erste Leiterbahnen 38 und zweite Leiterbahnen 40 auf. Über die leitfähige Verklebung 20 stehen die ersten Leiterbahnen 38 mit den ersten Elektroden 16 und die zweiten Leiterbahnen 40 mit den zweiten Elektroden 18 der piezoelektrischen Elemente 14 in Verbindung. Dabei ist es je nach Ausführungsvariante möglich, die leitfähige Verklebung 20, wie mit Bezug zu der ersten Ausführungsform in Figur 1 skizziert, nur in den Bereichen vorzusehen, an denen eine elektrische Verbindung zwischen der ersten Metallisierung 32 und einer der Elektroden 16, 18 des piezoelektrischen Elements 14 hergestellt werden soll. Alternativ ist es denkbar, eine anisotrope leitfähige Verklebung 21 flächig über die gesamte, den Einzelwandlern 10 zugewandten Seite der flexiblen Folie 30 auszuführen, wobei ein leitfähiger Klebstoff mit anisotroper Leitfähigkeit eingesetzt wird. Ein solcher anisotroper Leitkleber weist lediglich in einer Richtung senkrecht zur Ebene der flexiblen Folie eine Leitfähigkeit auf, so dass kein Kurzschluss zwischen den ersten Leiterbahnen 38 und den zweiten Leiterbahnen 40 bzw. den ersten Elektroden 16 und den zweiten Elektroden 18 entsteht.

Nach dem Verkleben der Einzelwandler 10 mit der flexiblen Folie 30 werden diese mit dem Vergussmaterial 60 umschlossen, so dass alle Oberflächen der Einzelwandler 10, die nicht mit der flexiblen Folie 30 verklebt sind, von dem Vergussmaterial 60 überdeckt werden.

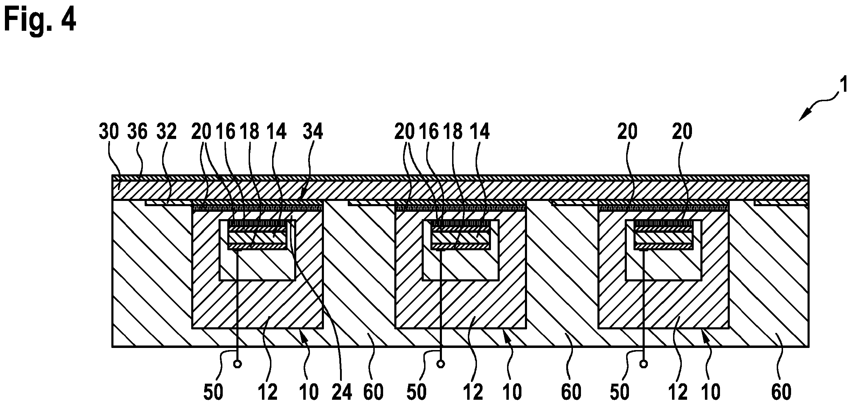

In der Figur 4 ist eine vierte Ausführungsform des Schallwandlers dargestellt.

In der Figur 4 ist wiederum der Schallwandler 1 mit dem Array von drei Einzelwandlern 10 dargestellt. Die Einzelwandler 10 der vierten Ausführungsform umfassen einen Träger 12 der U-förmig ausgestaltet ist, wobei zwischen den beiden Schenkeln des Trägers 12 eine Membran 24 angeordnet ist. Bei der Ausführungsform der Figur 4 sind die Membran 24 und der Träger 12 einstückig ausgebildet. Ferner besteht der Träger 12 aus einem elektrisch leitfähigen Material.

Die flexible Folie 30 weist, wie im Zusammenhang mit der ersten Ausführungsform beschrieben, die erste Metallisierung 32 auf, wobei in der ersten Metallisierung 32 Kontaktflächen 34 ausgebildet sind. Die Einzelwandler 10 sind mit ihrer Membran 24 über die leitfähige Verklebung 20 mit den Kontaktflächen 34 verklebt.

Die piezoelektrischen Elemente 14 gemäß der vierten Ausführungsform weisen ebenfalls wie zuvor beschrieben die erste Elektrode 16 und die zweite Elektrode 18 auf, wobei die piezoelektrischen Elemente 14 auf der der flexiblen Folie 30 abgewandten Seite der Membran 24 angeordnet sind. Dazu sind die ersten Elektroden 16 der piezoelektrischen Elemente 14 mit der leitfähigen Verklebung 20 mit der Membran 24 verbunden. Somit besteht eine elektrische Verbindung zwischen der ersten Metallisierung 32 über die Kontaktflächen 34 und eine leitfähige Verklebung 20 mit der Membran 24 und, da die Membran 24 wie auch der Träger 12 leitfähig ist, mit der ersten Elektrode 16.

Die zweite Elektrode 18 ist in der vierten Ausführungsform, wie bereits mit dem Bezug zur ersten Ausführungsform beschrieben, über den oder die Drähte 50 kontaktiert. Ebenfalls wie zuvor beschrieben, sind die Einzelwandler 10 so mit dem Vergussmaterial 60 umschlossen, dass das Vergussmaterial 60 alle Oberflächen der Einzelwandler 10, die nicht mit der flexiblen Folie 30 verklebt sind, überdeckt.

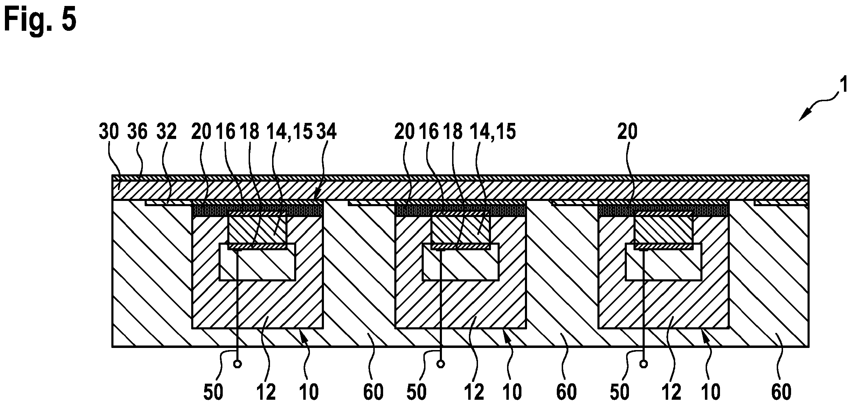

Figur 5 zeigt eine fünfte Ausführungsform des Schallwandlers.

In Figur 5 ist ein Schallwandler 1 gemäß einer fünften Ausführungsform dargestellt. Der Schallwandler 1 umfasst wie zuvor beschrieben ein Array von Einzelwandlern 10, die durch Verkleben mit der flexiblen Folie 30 verbunden sind. Dabei weist die flexible Folie 30 wie mit Bezug zur ersten Ausführungsform beschrieben eine erste Metallisierung 32 auf, in der Kontaktflächen 34 ausgebildet sind.

Die Einzelwandler 10 umfassen in der fünften Ausführungsform einen Träger 12, der aus einem piezokeramischen Material gefertigt ist und in Form eines rechteckförmigen Rahmens ausgestaltet ist. Dabei ist im Bereich einer Kante, die der flexiblen Folie 30 zugewandt ist, ein polarisierter Bereich 15 angeordnet, der das piezoelektrische Element 14 darstellt. Der Träger 12 aus dem piezokeramischen Material weist nur in diesem polarisierten Bereich 15 piezoelektrische Eigenschaften auf. Die erste Elektrode 16 und die zweite Elektrode 18 des piezoelektrischen Elements 14 sind entsprechend an zwei entgegengesetzten Seiten des polarisierten Bereichs 15 angeordnet, wobei die erste Elektrode 16 der flexiblen Folie 30 zugewandt ist und die zweite Elektrode 18 sich an der von der flexiblen Folie 30 abgewandten Seite des polarisierten Bereichs 15 befindet.

Die elektrische Kontaktierung des piezoelektrischen Elements 14 erfolgt wie mit Bezug zur ersten Ausführungsform beschrieben. Dabei wird die erste Elektrode 16 über die leitfähige Verklebung 20 mit den Kontaktflächen 34 verbunden, während die zweite Elektrode 18 eines jeden Einzelwandlers 10 mit dem Draht 50 kontaktiert ist.

Wie bei den vorangegangenen vier Ausführungsformen beschrieben, sind die Einzelwandler 10 mit dem Vergussmaterial 60 umschlossen.

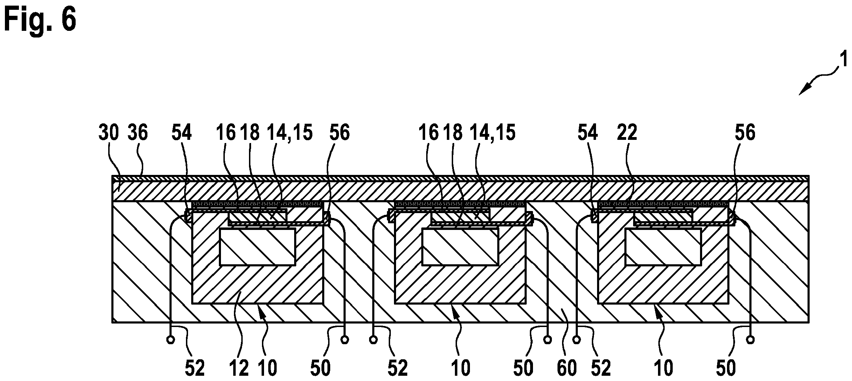

In Figur 6 ist eine sechste Ausführungsform des Schallwandlers dargestellt.

In Figur 6 ist eine sechste Ausführungsform des Schallwandlers 1 dargestellt, der wiederum ein Array von Einzelwandlern 10 umfasst, die mit der flexiblen Folie 30 verklebt sind.

Die flexible Folie 30 der sechsten Ausführungsform umfasst keine erste Metallisierung 32, sondern lediglich eine zweite Metallisierung 36, welche wie mit Bezug zur ersten Ausführungsform beschrieben, als Abschirmung dient.

Die Einzelwandler 10 umfassen, wie mit Bezug zur fünften Ausführungsform beschrieben, einen Träger 12 aus einem piezokeramischen Material, welches in Form eines rechteckigen Rahmens ausgestaltet ist. Ferner ist wie mit Bezug zur fünften Ausführungsform beschrieben ein polarisierter Bereich 15 an einer der flexiblen Folie 30 zugewandten Kante des Trägers 12 angeordnet, der als piezoelektrisches Element 14 dient. Zur elektrischen Kontaktierung sind dem piezoelektrischen Element 14 wieder die erste Elektrode 16 und die zweite Elektrode 18 zugeordnet, wobei die erste Elektrode 16 das piezoelektrische Element 14 auf der der flexiblen Folie 30 zugewandten Seite elektrisch kontaktiert und die zweite Elektrode 18 das piezoelektrische Element 14 an der der flexiblen Folie 30 abgewandten Seite elektrisch kontaktiert. Um eine elektrische Verbindung zu den ersten Elektroden 16 und den zweiten Elektroden 18 herzustellen, sind an den Trägern 12 seitliche Kontakte 54, 56 angeordnet. Die seitlichen Kontakte 54, 56 befinden sich an den Seitenwänden des im Wesentlichen als rechteckiger Rahmen ausgeführten Trägers 12, die an die der flexiblen Folie 30 zugewandten Kante anschließen und senkrecht zur flexiblen Folie 30 ausgerichtet sind. Dabei steht ein seitlicher Kontakt 54 mit der ersten Elektrode 16 in Verbindung und ein weiterer seitlicher Kontakt 56 mit der zweiten Elektrode 18 in elektrischer Verbindung. Über einen Draht 50 werden jeweils die weiteren seitlichen Kontakte 56 kontaktiert, die den zweiten Elektroden 18 zugeordnet sind, und mit weiteren Drähten 52 werden die seitlichen Kontakte 54 kontaktiert, die den ersten Elektroden 16 zugeordnet sind.

Da sowohl die ersten Elektroden 16 als auch die zweiten Elektroden 18 der Einzelwandler 10 über Drähte 50, 52 kontaktiert werden, ist in der sechsten Ausführungsform keine Metallisierung der den Einzelwandlern 10 zugewandten Seite der flexiblen Folie 30 erforderlich. Ferner kann für die Verbindung der Einzelwandler 10 mit der flexiblen Folie 30 ein Klebstoff verwendet werden, der nicht elektrisch leitfähig ist. Über jeweils eine Verklebung 22 werden die Einzelwandler 10 so mit der flexiblen Folie 30 verklebt, dass deren piezoelektrisches Element 14 in Richtung der flexiblen Folie 30 zeigt.

Je nach Ausführungsvariante kann die Verklebung 22, mit der die Einzelwandler 10 mit der flexiblen Folie 30 verbunden werden, flächig erfolgen, wobei der Klebstoff über die gesamte Fläche der flexiblen Folie 30 aufgetragen wird. Alternativ kann der Klebstoff lediglich in den Bereichen aufgetragen werden, an denen die Einzelwandler 10 mit der flexiblen Folie 30 in Verbindung treten. Ebenso ist es denkbar, für die Verklebung 22 den Klebstoff auf die Einzelwandler 10 aufzutragen und diese anschließend auf der flexiblen Folie 30 zu platzieren.

Wie bei den vorangegangenen Ausführungsformen bereits beschrieben, sind die nicht mit der flexiblen Folie 30 verklebten Oberflächen der Einzelwandler 10 von dem Vergussmaterial 60 umschlossen.

Die Erfindung ist nicht auf die hier beschriebenen Ausführungsbeispiele und die darin hervorgehobenen Aspekte beschränkt. Vielmehr sind innerhalb des durch die Ansprüche angegebenen Bereichs eine Vielzahl von Abwandlungen möglich, die im Rahmen fachmännischen Handelns liegen.

## Patentansprüche

1. Schallwandler (1) umfassend eine Vielzahl von Einzelwandlern (10), wobei die Einzelwandler (10) einen Träger (12) und ein piezoelektrisches Element (14) mit einer ersten Elektrode (16) und einer zweiten Elektrode (18) umfassen, wobei die Einzelwandler (10) in Form eines Arrays auf einer flexiblen Folie (30) aufgeklebt sind und **dadurch gekennzeichnet, dass** alle nicht mit der flexiblen Folie (30) verbundenen Oberflächen der Einzelwandler (10) von einem Vergussmaterial (60) mit schwingungsdämpfenden Eigenschaften umgeben sind.

2. Schallwandler (1) nach Anspruch 1, **dadurch gekennzeichnet, dass** die flexible Folie (30) auf der den Einzelwandlern (10) zugewandten Seite eine erste Metallisierung (32) aufweist und die erste Elektrode (16) eines jeden Einzelwandlers (10) über die erste Metallisierung (32) der flexiblen Folie (30) elektrisch kontaktiert ist.

3. Schallwandler (1) nach Anspruch 1, **dadurch gekennzeichnet, dass** die flexible Folie (30) auf der den Einzelwandlern (10) zugewandten Seite eine erste Metallisierung (32) aufweist, wobei der Träger (12) jedes Einzelwandlers (10) elektrisch leitfähig ausgeführt ist und an seiner der flexiblen Folie (30) zugewandten Seite eine Membran (24) aufweist, wobei das piezoelektrische Element (14) auf der der flexiblen Folie (30) abgewandten Seite der Membran (24) angeordnet ist, der Träger (12) die erste Elektrode (16) elektrisch kontaktiert und der Träger (12) mit der ersten Metallisierung (32) elektrisch verbunden ist.

4. Schallwandler (1) nach einem der Ansprüche 1 bis 3, **dadurch gekennzeichnet, dass** die zweite Elektrode (18) eines jeden Einzelwandlers (10) mittels eines durch das Vergussmaterial (60) und am Träger (12) vorbeiführenden Drahtes (50) elektrisch kontaktiert ist.

5. Schallwandler (1) nach Anspruch 1 oder 2, **dadurch gekennzeichnet, dass** der Träger (12) jedes Einzelwandlers (10) elektrisch leitfähig ausgeführt ist, der Träger (12) die zweite Elektrode (18) elektrisch kontaktiert und der Träger (12) über einen durch das Vergussmaterial (60) hindurchführenden Draht (50) elektrisch kontaktiert ist.

6. Schallwandler (1) nach Anspruch 2, **dadurch gekennzeichnet, dass** die erste Metallisierung (32) in Form von Leiterbahnen (38, 40) strukturiert ist, wobei die erste Elektrode (16) eines jeden Einzelwandlers (10) durch erste Leiterbahnen (38) elektrisch kontaktiert ist und die zweite Elektrode (18) eines jeden Einzelwandlers (10) mit zweiten Leiterbahnen (40) elektrisch kontaktiert ist.

7. Schallwandler (1) nach Anspruch 1, **dadurch gekennzeichnet, dass** am Träger (12) sowohl für die erste Elektrode (16) als auch die zweite Elektrode (18) seitlich Kontakte (54, 56) herausgeführt sind, die jeweils mit einem Draht (50, 52) durch das Vergussmaterial (60) hindurch elektrisch kontaktiert sind.

8. Schallwandler (1) nach einem der Ansprüche 1, 2, 4, 6 oder 7 **dadurch gekennzeichnet, dass** der Träger (12) aus einem piezokeramischen Material gefertigt ist und das piezoelektrische Element (14) als ein polarisierter Bereich (15) des Trägers (12) ausgebildet ist.

9. Schallwandler (1) nach einem der Ansprüche 1 bis 8, **dadurch gekennzeichnet, dass** die den Einzelwandlern (10) abgewandte Seite der flexiblen Folie (30) eine zweite Metallisierung (36) aufweist.

10. Verfahren zur Herstellung eines Schallwandlers (1) nach einem der Ansprüche 1 bis 9, umfassend die Schritte
a) Bereitstellen der flexiblen Folie (30) und der Einzelwandler (10),
b) Verkleben der Einzelwandler (10) mit der flexiblen Folie (30), wobei die Einzelwandler (10) in Form eines Arrays auf der flexiblen Folie (30) angeordnet werden,
c) Umschließen der Einzelwandler (10) mit dem Vergussmaterial (60) mit schwingungsdämpfenden Eigenschaften, so dass alle nicht mit der flexiblen Folie (30) verbundenen Oberflächen der Einzelwandler (10) von dem Vergussmaterial (60) umgeben sind.

11. Verfahren nach Anspruch 10, **dadurch gekennzeichnet, dass** ein leitfähiger Kleber beim Verkleben gemäß Schritt b) flächig auf die flexible Folie (30) aufgetragen wird, wobei der leitfähige Kleber insbesondere ein anisotroper Leitkleber ist.

12. Verfahren nach Anspruch 10 oder 11, **dadurch gekennzeichnet, dass** nach dem Verkleben gemäß Schritt b) und vor dem Umschließen gemäß Schritt c) die erste Elektrode (16) und/oder die zweite Elektrode (18) eines jeden Einzelwandlers (10) durch Bonden, Thermokompressionsschweißen, Löten oder Leitkleben eines Drahtes (50, 52) elektrisch kontaktiert werden.

## Claims

1. Sound transducer (1) comprising a plurality of single transducers (10), wherein the single transducers (10) have a carrier (12) and a piezoelectric element (14) with a first electrode (16) and a second electrode (18), wherein the single transducers (10) are adhesively attached to a flexible film (30) in the form of an array, and **characterized in that** all of the surfaces of the single transducers (10) that are not connected to the flexible film (30) are surrounded by an encapsulating material (60) having vibration damping properties.

2. Sound transducer (1) according to Claim 1, **characterized in that** the flexible film (30) has a first metallization (32) on the side facing the single transducers (10) and the first electrode (16) of each single transducer (10) is electrically contacted by way of the first metallization (32) of the flexible film (30) .

3. Sound transducer (1) according to Claim 1, **characterized in that** the flexible film (30) has a first metallization (32) on the side facing the single transducers (10), wherein the carrier (12) of each single transducer (10) is designed as electrically conductive and has a membrane (24) on its side facing the flexible film (30), wherein the piezoelectric element (14) is arranged on the side of the membrane (24) facing away from the flexible film (30), the carrier (12) electrically contacts the first electrode (16) and the carrier (12) is electrically connected to the first metallization (32).

4. Sound transducer (1) according to one of Claims 1 to 3, **characterized in that** the second electrode (18) of each single transducer (10) is electrically contacted by means of a wire (50) passing through the encapsulating material (60) and past the carrier (12).

5. Sound transducer (1) according to Claim 1 or 2, **characterized in that** the carrier (12) of each single transducer (10) is designed as electrically conductive, the carrier (12) electrically contacts the second electrode (18) and the carrier (12) is electrically contacted by way of a wire (50) passing through the encapsulating material (60).

6. Sound transducer (1) according to Claim 2, **characterized in that** the first metallization (32) is structured in the form of conductor tracks (38, 40), wherein the first electrode (16) of each single transducer (10) is electrically contacted by first conductor tracks (38) and the second electrode (18) of each single transducer (10) is electrically contacted by second conductor tracks (40).

7. Sound transducer (1) according to Claim 1, **characterized in that** contacts (54, 56), which are each electrically contacted by a wire (50, 52) passing through the encapsulating material (60) are led out laterally at the carrier (12), both for the first electrode (16) and for the second electrode (18).

8. Sound transducer (1) according to one of Claims 1, 2, 4, 6 or 7, **characterized in that** the carrier (12) is produced from a piezoceramic material and the piezoelectric element (14) is formed as a polarized region (15) of the carrier (12).

9. Sound transducer (1) according to one of Claims 1 to 8, **characterized in that** the side of the flexible film (30) facing away from the single transducers (10) has a second metallization (36).

10. Method for producing a sound transducer (1) according to one of Claims 1 to 9, comprising the steps of
a) providing a flexible film (30) and the single transducers (10),
b) adhesively bonding the single transducers (10) to the flexible film (30), wherein the single transducers (10) are arranged on the flexible film (30) in the form of an array,
c) enclosing the single transducers (10) with the encapsulating material (60) having vibration damping properties, so that all of the surfaces of the single transducers (10) that are not connected to the flexible film (30) are surrounded by the encapsulating material (60) .

11. Method according to Claim 10, **characterized in that**, during the adhesive bonding according to step b), a conductive adhesive is applied to the flexible film (30) over its surface area, wherein the conductive adhesive is in particular an anisotropic conductive adhesive.

12. Method according to Claim 10 or 11, **characterized in that**, after the adhesive bonding according to step b) and before the enclosing according to step c), the first electrode (16) and/or the second electrode (18) of each single transducer (10) is/are electrically contacted by bonding, thermocompression welding, soldering or conductive adhesive bonding of a wire (50, 52).

## Revendications

1. Transducteur acoustique (1), comprenant une pluralité de transducteurs individuels (10), les transducteurs individuels (10) comprenant un support (12) et un élément piézoélectrique (14) doté d'une première électrode (16) et d'une deuxième électrode (18), les transducteurs individuels (10) étant collés sous forme de réseau sur un film souple (30), et **caractérisé en ce que** toutes les surfaces non reliées au film souple (30) des transducteurs individuels (10) sont entourées d'une matière de scellement (60) ayant des propriétés amortissant les vibrations.

2. Transducteur acoustique (1) selon la revendication 1, **caractérisé en ce que** le film souple (30) présente une première métallisation (32) sur la face tournée vers les transducteurs individuels (10), et la première électrode (16) de chaque transducteur individuel (10) est mise en contact électrique par l'intermédiaire de la première métallisation (32) du film souple (30).

3. Transducteur acoustique (1) selon la revendication 1, **caractérisé en ce que** le film souple (30) présente une première métallisation (32) sur la face tournée vers les transducteurs individuels (10), le support (12) de chaque transducteur individuel (10) étant réalisé de manière électriquement conductrice et présentant une membrane (24) sur sa face tournée vers le film souple (30), l'élément piézoélectrique (14) étant disposé sur la face de la membrane (24), détournée du film souple (30), le support (12) mettant en contact électrique la première électrode (16), et le support (12) étant relié électriquement à la première métallisation (32).

4. Transducteur acoustique (1) selon l'une quelconque des revendications 1 à 3, **caractérisé en ce que** la deuxième électrode (18) de chaque transducteur individuel (10) est mise en contact électrique au moyen d'un fil métallique (50) passant à travers la matière de scellement (60) et devant le support (12).

5. Transducteur acoustique (1) selon la revendication 1 ou 2, **caractérisé en ce que** le support (12) de chaque transducteur individuel (10) est réalisé de manière électriquement conductrice, le support (12) met en contact électrique la deuxième électrode (18), et le support (12) est mis en contact électrique par un fil métallique (50) passant à travers la matière de scellement (60).

6. Transducteur acoustique (1) selon la revendication 2, **caractérisé en ce que** la première métallisation (32) est structurée sous la forme de pistes conductrices (38, 40), la première électrode (16) de chaque transducteur individuel (10) étant mise en contact électrique par des premières pistes conductrices (38) et la deuxième électrode (18) de chaque transducteur individuel (10) étant mise en contact électrique avec des deuxièmes pistes conductrices (40).

7. Transducteur acoustique (1) selon la revendication 1, **caractérisé en ce que** sur le support (12), à la fois pour la première électrode (16) et la deuxième électrode (18), des contacts (54, 56) sont sortis sur le côté qui sont respectivement mis en contact électrique avec un fil métallique (50, 52) à travers la matière de scellement (60).

8. Transducteur acoustique (1) selon l'une quelconque des revendications 1, 2, 4, 6 ou 7, **caractérisé en ce que** le support (12) est fabriqué à partir d'un matériau piézocéramique, et l'élément piézoélectrique (14) est réalisé sous la forme d'une zone polarisée (15) du support (12).

9. Transducteur acoustique (1) selon l'une quelconque des revendications 1 à 8, **caractérisé en ce que** la face du film souple (30), détournée des transducteurs individuels (10), présente une deuxième métallisation (36) .

10. Procédé de fabrication d'un transducteur acoustique (1) selon l'une quelconque des revendications 1 à 9, comprenant les étapes consistant à
a) fournir le film souple (30) et les transducteurs individuels (10),
b) coller les transducteurs individuels (10) avec le film souple (30), les transducteurs individuels (10) étant disposés sous la forme d'un réseau sur le film souple (30),
c) enrober les transducteurs individuels (10) avec la matière de scellement (60) ayant des propriétés amortissant les vibrations de sorte que toutes les surfaces des transducteurs individuels (10) non reliées au film souple (30) sont entourées de la matière de scellement (60).

11. Procédé selon la revendication 10, **caractérisé en ce que** lors du collage selon l'étape b), un adhésif conducteur est appliqué sur toute la surface sur le film souple (30), l'adhésif conducteur étant en particulier un adhésif conducteur anisotrope.

12. Procédé selon la revendication 10 ou 11, **caractérisé en ce qu'**après le collage selon l'étape b) et avant l'enrobage selon l'étape c), la première électrode (16) et/ou la deuxième électrode (18) de chaque transducteur individuel (10) est/sont mise(s) en contact électrique par liaison, soudage par thermocompression, brasage ou collage conducteur d'un fil métallique (50, 52).
